# FASCICULE DE BREVET EUROPEEN

(11) **EP 3 743 951 B1**
(45) Date de publication et mention de la délivrance du brevet: **10.11.2021**
(21) Numéro de dépôt: 19704360.7
(22) Date de dépôt: 18.01.2019
(51) Int. Cl.: H01L 41/09, H01L 41/047, B06B 1/02

(54) **PROCEDES DE CONCEPTION ET DE FABRICATION D'UN DISPOSITIF COMPRENANT UN RESEAU D'ELEMENTS MICRO-USINES**
VERFAHREN ZUR GESTALTUNG UND HERSTELLUNG EINER VORRICHTUNG AUS EINEM MIKROFABRIZIERTEN ELEMENTENETZWERK
METHODS FOR DESIGNING AND MANUFACTURING A DEVICE COMPRISING A MICROFABRICATED ELEMENT NETWORK

(30) Priorité: 22.01.2018 FR 1850484
(43) Date de publication de la demande: 02.12.2020
(73) Titulaire: SOITEC, 38190 Bernin (FR)
(72) Inventeur: GHYSELEN, Bruno, 38170 SEYSSINET (FR)
(74) Mandataire: IP Trust
(86) Numéro de dépôt international: PCT/FR2019/050108
(87) Numéro de publication internationale: WO 2019/141952

(56) Documents cités:
- FR-A1- 2 880 341
- US-A1- 2016 051 225
- US-A1- 2017 328 870

## Description

### DOMAINE DE L'INVENTION

La présente invention concerne les dispositifs comprenant un réseau d'éléments micro-usinés disposé dans un plan. Elle concerne notamment tout dispositif acoustique mettant en œuvre un réseau de transducteurs ultrasonores micro-usinés. Ces transducteurs peuvent être de nature capacitive ou piézo-électrique. Elle trouve par exemple son application dans le domaine de l'imagerie à ultrason.

### ARRIERE PLAN TECHNOLOGIQUE DE L'INVENTION

Le document (D1) Lu, Yipeng, and David A. Horsley. "Modeling, fabrication, and characterization of piezoelectric micromachined ultrasonic transducer arrays based on cavity SOI wafers." Journal of Microelectromechanical Systems 24.4 (2015): 1142-1149 rappelle que les transducteurs ultrasonores micro-usinés (MUT selon l'acronyme de l'expression anglo-saxonne « Micromachined Ultrasonic Transducer ») sont formés d'une membrane surplombant une cavité, la membrane présentant une faible impédance acoustique et un bon couplage à l'air ou un autre fluide dans lequel se propage une onde acoustique. En mode récepteur, le fléchissement de la membrane sous l'effet de l'onde acoustique, est converti en un signal électrique. En mode émetteur, un signal électrique impose un fléchissement à la membrane pour générer une onde acoustique.

Les documents FR2880341, US2016051225, US2017328870, US20130270967, US20140219063 et US20170128983 fournissent d'autres illustrations de dispositifs MUT, et de leur procédé de fabrication.

La technologie MUT permet de concevoir des dispositifs acoustiques trouvant par exemple des applications dans le domaine de l'imagerie et présente de nombreux avantages, notamment son intégration facile à l'électronique de conditionnement du signal, sa faible consommation, une bande passante étendue et une fabrication aisée sous la forme d'un réseau étendu de transducteurs disposés dans un plan.

Ce document rappelle également que ces transducteurs peuvent être classés en deux catégories selon le mécanisme d'activation de la membrane.

Les MUTs capacitifs, dont on a représenté schématiquement une coupe sur la figure la, présentent deux électrodes la, 1b, l'une disposée sur la membrane 2, l'autre étant généralement formé par le fond de la cavité 3 que la membrane surplombe. Cette seconde électrode peut donc consister en un simple contact 1b pris sur le support 4 sur lequel la cavité 3 repose. Les deux électrodes constituent une capacité dont la valeur dépend du degré de flexion de la membrane.

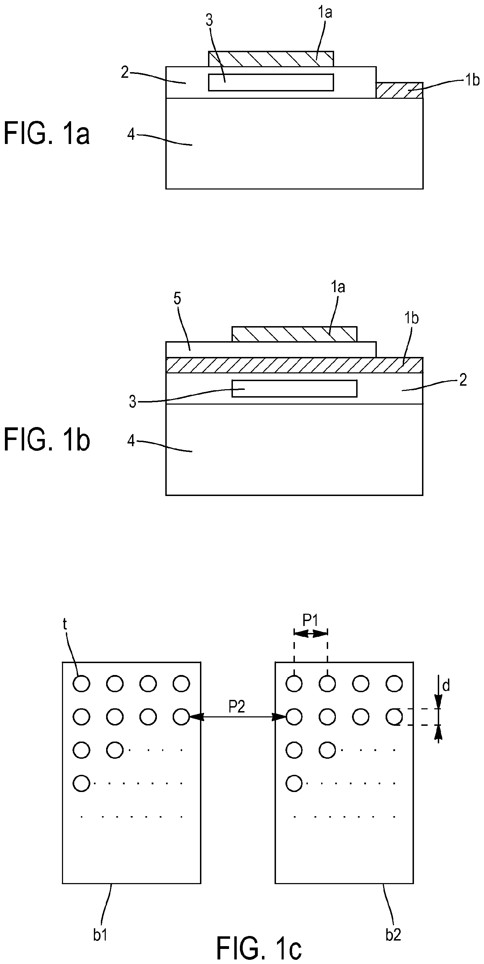

Les MUTs piézoélectriques, dont on a représenté schématiquement une coupe sur la figure 1b, présentent également deux électrodes la, 1b disposées sur la membrane 2, de part et d'autre d'une couche de matériaux piézoélectrique 5. Dans ce type de dispositif, la couche de matériaux piézo-électriques 5 est couplée à la membrane 3 pour la faire fléchir ou suivre son fléchissement.

Quel que soit le type de MUTs qu'un dispositif acoustique emploi, ceux-ci sont généralement disposés dans un plan et selon une topologie déterminée, comme cela est bien illustré dans le document (D2) Ergun, Arif S., Goksen G. Yaralioglu, and Butrus T. Khuri-Yakub. "Capacitive micromachined ultrasonic transducers: Theory and technology." Journal of aerospace engineering 16.2 (2003): 76-84.

Par « topologie » on désigne, dans le cadre de la présente demande, la géométrie de chaque transducteur et notamment la forme et les dimensions (largeur, longueur ou diamètre, profondeur) de la cavité et de la membrane associée qu'il comprend, ainsi que la répartition dans le plan des transducteurs formant le dispositif acoustique.

On a ainsi représenté très schématiquement sur la figure 1c, un exemple de topologie comprenant une pluralité de blocs de transducteurs b1, b2, les blocs étant séparés les uns des autres d'une distance de séparation de bloc p2 (pris entre le centre de deux transducteurs disposés en vis-à-vis sur des bords opposés de deux blocs b1, b2). Un dispositif peut comprendre un, voire plusieurs centaines de tels blocs, séparés les uns des autres par exemple d'une distance p2 de l'ordre de 10 à 100 µm.

L'espace disponible entre chaque bloc est généralement mis à profit pour placer des contacts, des pistes ou d'autres éléments permettant par exemple de relier les transducteurs à un circuit de conditionnement. Chaque bloc présente une longueur et une largeur déterminée (qui peut s'exprimer en nombre de transducteurs selon chacune de ces dimensions) et délimitent un réseau 2D de transducteurs t généralement régulièrement distribués. Un bloc peut comprendre plusieurs milliers de transducteurs. Chaque transducteur est séparé d'un transducteur voisin d'une distance de séparation déterminée p1, typiquement compris entre un µm à 100 µm. Chaque transducteur comprend une membrane surplombant une cavité qui présente, dans l'exemple représenté, une forme circulaire et un diamètre d (de quelques µm à quelques centaines de µm). La topologie est également définie par la profondeur des cavités, qui peut s'étendre entre un µm ou moins à plusieurs dizaines de µm ou plus.

La conception d'un dispositif acoustique requiert généralement de définir précisément la topologie qui sera employée, c'est à dire le nombre et le dimensionnement des blocs de transducteurs, la distance de séparation de bloc, la disposition des transducteurs au sein d'un bloc, par exemple sous forme matricielle en fixant la distance de séparation entre deux transducteurs, la dimension et la forme des cavités de chaque transducteur, ... Les fonctionnalités et la performance attendues du dispositif acoustique dictent, dans une certaine mesure, ces paramètres de conception. A ce titre, il n'est pas nécessaire que tous les transducteurs ou tous les blocs de transducteurs composant un dispositif acoustique présentent tous les mêmes dimensions ou soient répartis selon un arrangement unique.

Le document US2013270967 rappelle également qu'il existe plusieurs méthodes de fabrication d'un dispositif acoustique à base de transducteurs MUTs, selon que les transducteurs sont fabriqués en même temps, après, ou séparément des circuits électriques analogiques et numériques de conditionnement des signaux. Ce document propose ainsi un procédé simplifié de fabrication d'un dispositif acoustique dans lequel les transducteurs sont fabriqués séparément des circuits de conditionnement. Ce procédé tire profit des cavités préalablement formées dans un substrat pour limiter le nombre de niveaux de masques photo-lithographiques devant être employés.

L'approche est séduisante, mais elle fait porter une partie de l'effort de conception du dispositif acoustique au fabricant du substrat. Celui-ci doit en effet être apte à concevoir et à fabriquer un substrat comportant des cavités se conformant précisément à la topologie choisie pour le dispositif. Or, cette topologie forme souvent une information sensible et de valeur que le fabricant de dispositif ne souhaite généralement pas diffuser.

De plus, le fabricant de substrat doit développer des procédés de fabrication de substrats spécifiques à chaque topologie. Cet effort ne favorise pas le développement rapide et économique du dispositif acoustique.

Il serait donc souhaitable de pouvoir fournir un substrat comportant des cavités qui puissent servir à la fabrication d'une vaste gamme de dispositifs acoustiques et qui ne nécessiterait donc pas le développement à façon, pour chaque dispositif acoustique, d'un procédé de fabrication spécifique de substrats.

### BREVE DESCRIPTION DE L'INVENTION

En vue de la réalisation de l'un de ces buts, l'objet de l'invention propose un procédé de conception d'un dispositif comprenant une pluralité d'éléments micro-usinés comprenant chacun une membrane flexible, les éléments étant disposés dans un plan selon une topologie déterminée. Le procédé de conception comprend une étape de définition de la topologie déterminée pour qu'elle présente un caractère compatible avec un substrat générique présentant des cavités dont les caractéristiques sont préétablies, chaque membrane flexible des éléments micro-usinés étant associée à une cavité du substrat générique.

De la sorte, on définit une règle de conception qui impose la topologie au dispositif de telle sorte que les membranes soient en correspondance avec les cavités du substrat générique. Il n'est donc pas nécessaire de développer un substrat particulier adapté à la topologie du dispositif.

Selon d'autres caractéristiques avantageuses et non limitatives de l'invention, prises seules ou selon toute combinaison techniquement réalisable :
- au cours de l'étape de définition de la topologie, le substrat générique est choisi dans un groupe de substrats génériques, les substrats ayant des caractéristiques préétablies les différentiant les uns des autres ;
- l'étape de définition comprend la sélection du substrat générique dans le groupe de substrats génériques, conduisant à définir la topologie déterminée pour qu'elle soit la plus semblable possible à une topologie souhaitée ;
- le procédé de conception comprend également la définition des épaisseurs des membranes ;
- l'étape de définition de la topologie déterminée consiste à
   ∘ Choisir la dimension et la forme des membranes des éléments pour qu'elles correspondent à la dimension et à la forme des cavités du substrat générique ;
   ∘ Choisir la disposition des membranes des éléments micro usinés dans le plan pour qu'elles soient toutes au droit d'une cavité du substrat générique lorsque le dispositif est mis en correspondance avec ce substrat ;
- la disposition des cavités du substrat générique est régulière et couvre toute son étendue ;
- les éléments micro usinés sont des transducteurs ultrasonores ou acoustiques micro-usinés ou des micro-miroirs ;
- Procédé de conception selon l'une des revendications précédentes dans lequel le substrat générique présente des cavités dont les tailles et/ou les formes ne sont pas toutes identiques entre elles. Selon un autre aspect, l'invention propose un procédé de fabrication du dispositif acoustique conçu qui comprend une étape de fourniture du substrat générique.

Plus généralement, l'invention propose un procédé de fabrication d'un dispositif comprenant une pluralité d'éléments micro-usinés selon la revendication indépendante 1.

Selon d'autres caractéristiques avantageuses et non limitatives de ce procédé de fabrication, prises seules ou selon toute combinaison techniquement réalisable :
- au moins une étape de traitement comprend une étape de réalisation d'un réseau d'éléments électriquement conducteurs configuré pour connecter une partie seulement des couples cavité-membrane ;
- la réalisation du réseau d'éléments électriquement conducteurs comprend la formation d'électrodes au droit d'une partie seulement des cavités ;
- le procédé comprend une étape d'ajustement de l'épaisseur des membranes flexibles ;
- le substrat générique comprend une couche intermédiaire entre la face principale du support et la couche superficielle ;
- le procédé comprend une étape de dépôt d'au moins une première électrode sur la couche superficielle ;
- le procédé comprend une étape de dépôt d'une couche piézoélectrique sur la première électrode au moins ;
- le procédé comprend une étape de dépôt d'une seconde électrode sur la couche piézoélectrique.

### BREVE DESCRIPTION DES DESSINS

D'autres caractéristiques et avantages de l'invention ressortiront de la description détaillée de l'invention qui va suivre en référence aux figures annexées sur lesquelles :
- Les figures 1a à 1c représentent respectivement un MUT capacitif, un MUT piézoélectrique, une topologie d'un dispositif acoustique de l'état de la technique ;
- les figures 2a à 2c représentent schématiquement une vue en coupe et de dessus d'un exemple de substrat générique ;

### DESCRIPTION DETAILLEE DE L'INVENTION

D'une manière très générale, un substrat générique présent des cavités (ou un groupe de tels substrats génériques), surplombées par des membranes. Elle vise d'autre part à définir des règles de conception d'un dispositif, notamment acoustique, de manière à ce qu'il puisse être fabriqué à partir d'un tel substrat générique. Certaines au moins des membranes et des cavités du substrat générique sont destinées à former des éléments micro-usinés fonctionnels, tels que des transducteurs d'un dispositif acoustique. De la sorte, on s'assure que le fabricant de substrat puisse fournir, en volume et à moindre coût, des substrats sans devoir ajuster le procédé de fabrication à un besoin spécifique de son client. Le fabricant de dispositifs, et notamment de dispositifs acoustiques, qui respecte les règles de conception peut, dans le même temps s'approvisionner en substrat sans partager toutes les caractéristiques, souvent confidentielles, de son produit.

Par « cavité », on désigne dans le cadre de la présente demande, tout évidemment formé dans un substrat. Il n'est pas nécessaire que cet évidemment soit entièrement fermé ou hermétiquement clos.

Par « membrane » ou « membrane flexible », on désigne toute structure suspendue au-dessus d'un évidemment du substrat. Elle peut présenter une forme quelconque, par exemple former une paroi ou une poutre. La structure suspendue peut être reliée au substrat au niveau de son contour, entièrement ou partiellement. Elle peut être également reliée au substrat au niveau d'un ou d'une pluralité de pieds. Quelle que soit la manière dont la structure est reliée au substrat, une partie au moins de cette structure présente au moins un degré de liberté de mouvement, la rendant flexible.

### Substrat générique

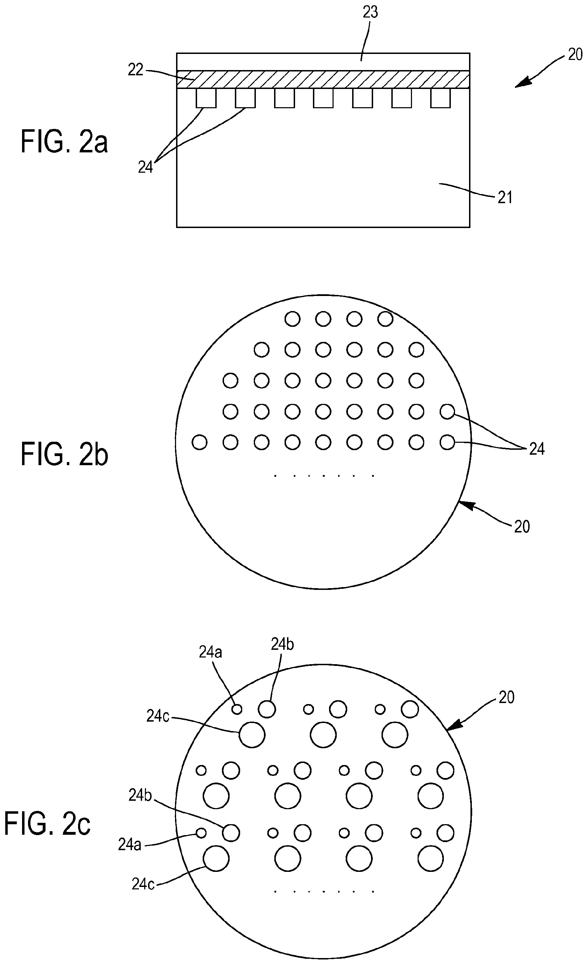

Selon un aspect, un substrat générique 20 comprend des cavités. Un tel substrat générique 20, dont on a représenté schématiquement un exemple en coupe sur la figure 2a et en vue de dessus sur la figure 2b, peut comprendre un support 21 et une couche superficielle 23 disposée sur le support. Elle peut également comprendre une couche intermédiaire 22 entre une face principale du support et la couche superficielle. Le support 21 comprend des cavités 24 débouchant sur sa face principale. Les parties de la couche superficielle 23 surplombant les cavités 24 du support 21 forme une membrane flexible.

Le substrat générique 20 peut être très facilement fabriqué par un procédé de type « collage et amincissement ». Un tel procédé comprend la fourniture du support 21 et la formation, sur la face principale de ce support 21, de cavités 24, par exemple par gravure sèche ou humide, en utilisant si nécessaire une étape de photolithographie d'une résine préalablement déposée sur la face principale du support 21 pour respectivement masquer ou ouvrir les zones à protéger de la gravure et les zones à graver.

Le procédé peut également comprendre la fourniture d'un substrat donneur et son assemblage au support 21 de manière à recouvrir les cavités débouchantes 24. L'un et/ou l'autre du support 21 et du substrat donneur peut avoir préalablement été muni de couches, par exemple de diélectriques, sur leurs faces destinées à être assemblées pour former la couche intermédiaire 22 enterrée du substrat 20. La ou les couches formées sur le support 21 peuvent être déposées avant ou après la gravure des cavités 24 débouchantes à la surface de ce support. Elle peut donc, selon une variante, tapisser les parois définissant ces cavités.

Dans une étape suivante, on procède à l'amincissement du substrat donneur, ce qui peut être effectué mécaniquement, chimiquement ou par fracture au niveau d'un plan fragilisé qui aurait été préalablement formé dans le substrat donneur, par exemple par implantation d'espèces gazeuses d'hélium et/ou d'hydrogène. La couche superficielle 23 peut présenter une épaisseur comprise entre 100 nm à plusieurs dizaines de µm, voire même plusieurs centaines de µm.

Dans certains cas, l'étape d'assemblage peut être réalisée dans une chambre d'assemblage dont l'atmosphère est contrôlée, par exemple pour présenter une pression de vide déterminée et/ou une nature de gaz particulier. On contrôle ainsi l'atmosphère présente dans la cavité, et notamment son niveau de vide et/ou la nature du gaz qui l'emplit.

Préférentiellement, l'étape d'assemblage est réalisée par adhésion moléculaire c'est à dire que les surfaces assemblées, propres et lisses, du support 24 et du substrat donneur adhèrent l'une à l'autre par des forces de type Van der Waals ou covalentes, et sans nécessiter l'application d'un adhésif. Les forces d'adhésion peuvent être renforcées par un traitement thermique dont la température peut être comprises entre 100°C et 1000°C ou plus, ou favorisées par un traitement chimique ou plasma des surfaces appelées à entrer en contact, avant leur assemblage.

Des variantes à ce procédé peuvent être envisagées. A titre d'exemple, et comme cela est bien connu en soi, les cavités 24 peuvent être formées ultérieurement à l'étape d'assemblage du substrat donneur et du support, et à l'étape d'amincissement du substrat donneur. Une manière de procéder répandue dans le domaine de la fabrication des dispositifs micro-usinés repose sur l'emploi de substrats de silicium sur isolant (généralement désigné par l'acronyme « SOI », de l'expression « Silicon On Insulator ») dans lequel sont gravées ces cavités 24. Les propriétés de gravure sélective entre le silicium et l'isolant enterré sont mises à profit pour réaliser les cavités 24 dans l'isolant enterré 22 du substrat SOI. En option, les ouvertures ayant permis de graver sélectivement les cavités 24 peuvent être rebouchées après leur formation, afin de notamment les rendre étanches.

Avantageusement, pour des raisons de disponibilité et de coût, le support 21 et le substrat donneur sont constitués de plaquettes de silicium. Il peut ainsi s'agir de plaquettes circulaires dont le diamètre peut être de 200mm, 300mm ou plus. Mais il peut tout à fait s'agir de plaquettes de matériaux différents ou de tous matériaux fournis sous une forme différente qu'une plaquette. On pourra notamment choisir le matériau du substrat donneur pour que la couche superficielle 23, et notamment les parties de cette couche surplombant les cavités 24 et formant des membranes présentent une raideur déterminée, permettant de contrôler le fléchissement de ces membranes lorsqu'elles sont mises sous contrainte. De la même manière, on pourra choisir la nature d'une éventuelle couche intermédiaire 22 pour modifier la raideur des membranes. On pourra également choisir de former la couche intermédiaire d'un matériau diélectrique, dioxyde de silicium ou nitrure de silicium par exemple, pour isoler électriquement la couche superficielle 23 du support 21.

On peut prévoir des marques d'alignement disposées dans la couche superficielle 23 ou sur les côtés du substrat générique 20 de manière à pouvoir repérer avec précision l'emplacement des cavités, et permettre de placer en parfait alignement avec ces cavités 24 des électrodes, et autres couches nécessaires pour compléter la fabrication de transducteurs, ou plus généralement d'éléments micro-usinés, et pour ainsi les rendre fonctionnels.

Le substrat 20 présente un caractère générique en ce que la forme, les dimensions, la disposition des cavités sur l'étendue du substrat ne sont pas spécifiques à un produit ou une application particuliers.

Ainsi, et comme cela est représenté sur l'exemple de la figure 2b, le substrat générique peut comprendre une pluralité de cavités 24 uniformément réparties sur toute l'étendue du substrat 20 et présentant toutes la même forme et les mêmes dimensions. Par l'expression « toute l'étendue du substrat » on désigne au moins une surface centrale de la face principale du substrat, ce qui peut exclure une zone périphérique de cette surface. Dans cet exemple, chaque cavité présente une forme circulaire dans le plan du substrat, de diamètre tous égaux à 40 µm, de profondeur de 0.2 µm et réparties uniformément aux intersections d'un quadrillage, dont les génératrices sont perpendiculaires entre elles. La distance séparant le centre d'une cavité au centre d'une autre cavité adjacente est égale à 100 µm.

La figure 2c représente une vue de dessus d'un deuxième exemple de substrat générique 20. Dans ce deuxième exemple, les cavités 24a, 24b, 24c sont disposées en groupes, les groupes de cavités étant uniformément répartis à la surface du substrat 20. Chaque groupe de cavité comprend, dans l'exemple représenté, trois cavités 24a, 24b, 24c de formes circulaires disposées à proximité les unes des autres, et présentant respectivement un diamètre de 20 µm, 40 µm et 60 µm. Les autres paramètres du substrat 20 sont les mêmes que ceux du premier exemple.

D'une manière plus générale, un substrat générique peut présenter une pluralité de groupe de cavités, chaque groupe de cavités présentant des caractéristiques (forme, dimensions...) différentes. Les groupes de cavités peuvent être disposés dans des zones distinctes de la surface du substrat ou, au contraire, les cavités de chaque groupe disposés côte à côte les unes des autres. Chaque groupe de cavités peut être destiné à former un élément micro-usiné ayant une fonction déterminée. A titre d'exemple, un premier groupe de cavités peut présenter des caractéristiques de cavités les rendant particulièrement adaptées à la formation de transducteurs d'émission, et un second groupe de cavités peut présenter des caractéristiques de cavités les rendant particulièrement adaptées à la formation de transducteurs de réception. Dans un deuxième exemple de réalisation, un premier groupe de cavités peut présenter des caractéristiques de cavités les rendant particulièrement adaptées à la formation de transducteurs basse fréquence, et un second groupe de cavités peut présenter des caractéristiques de cavités les rendant particulièrement adaptées à la formation de transducteurs haute fréquence.

On peut envisager, dans le cadre de la présente invention, de disposer d'une pluralité de types de substrats génériques 20. Par exemple, on peut prévoir de constituer une collection de types de substrats génériques sur le même modèle que celui présenté dans l'exemple des figures 2a, 2b, et pour lesquels le diamètre des cavités 24 est choisi respectivement à 5 µm, 20 µm, 40 µm et 60 µm.

D'une manière plus générale, les types de substrats de la collection présentent des caractéristiques préétablies les différentiant les uns des autres.

Chacun des types de substrats génériques 20 nécessite un procédé de fabrication spécifique qui doit s'ajuster à la taille des cavités 24 et au facteur de remplissage des surfaces qui sont mis en contact. Toutefois, le nombre de substrats génériques composant la collection étant limité, il est relativement aisé de préétablir ces procédés et de les mettre en œuvre selon le besoin en l'un ou l'autre de ces substrats.

Bien entendu, l'invention n'est nullement limitée à l'exemple de substrat générique 20 qui vient d'être donné. On peut envisager des cavités présentant une forme différente, par exemple carrée, rectangulaire ou encore hexagonale, une profondeur différente ou une disposition différente à la surface du support. Il n'est notamment pas nécessaire que cette disposition soit régulière ou qu'elle couvre toute l'étendue du substrat générique, bien que cela soit particulièrement avantageux et permette de limiter les contraintes lors de la conception d'un dispositif.

Dans tous les cas, l'invention prévoit qu'un nombre limité (par exemple 1, 3, 10 ou 20) de types de substrats génériques, dont les caractéristiques sont précisément prédéfinies, soit établi.

Procédé de conception d'un dispositif acoustique.

Selon un autre aspect, l'invention propose un procédé de conception d'un dispositif comprenant des éléments micro-usinés. Dans l'exemple dont la description suit, les éléments micro-usinés fonctionnels sont des transducteurs ultrasonores micro-usinés, et le dispositif est un dispositif acoustique. Ce procédé vise à établir un modèle du dispositif pour qu'il puisse être ultérieurement fabriqué sur un substrat générique. De manière complémentaire, il peut également établir les différentes étapes à mettre en œuvre pour fabriquer, à partir du substrat générique, le dispositif acoustique. Bien entendu, le procédé de conception prendra en compte la nature choisie, capacitive ou piézoélectrique, des transducteurs.

Un tel transducteur, on l'a vu, comprend une membrane flexible surplombant une cavité, qui peut être hermétiquement close et contenir une atmosphère contrôlée, et deux électrodes disposées d'un côté et de l'autre de la membrane et/ou de la cavité. Par ailleurs, les électrodes des transducteurs peuvent être disposées autrement. En effet, un groupe de couples cavité / membrane flexible associée distribuées côte à côte et formant un ou plusieurs transducteurs, peut être adressé par un seul couple d'électrodes disposées aux extrémités dudit groupe. On peut également envisager de disposer ces électrodes différemment, par exemple en les interdigitant sur une même face de la membrane, notamment lorsque celle-ci comprend un matériau piézoélectrique. Les transducteurs sont tous répartis dans un plan et selon une topologie déterminée. Par souci de clarté, on considèrera dans la présente description, que la forme et les dimensions dans le plan d'un transducteur correspondent précisément à la forme et aux dimensions de la membrane constituant ce transducteur.

La conception du dispositif acoustique comprend une étape dans laquelle on définit la topologie déterminée d'une pluralité de transducteurs, c'est à dire d'une pluralité d'éléments micro-usinés comprenant chacun une membrane flexible. Il peut ainsi s'agir de définir, selon le domaine d'application visé et le niveau de performance attendu par le dispositif, le nombre et les dimensions des blocs de transducteurs, la répartition des transducteurs dans chaque bloc, les distances séparant deux blocs adjacents, la forme et les dimensions de chaque transducteur à l'intérieur de chaque bloc.

Selon l'invention, cette étape de définition est conduite de manière à ce que la topologie définie présente un caractère compatible avec un substrat générique, c'est à dire pour laquelle les membranes flexibles des éléments micro-usinés peuvent être associées aux cavités du substrat générique. En d'autres termes, cette étape de définition impose que la topologie choisie respecte un ensemble de règles de conception assurant la compatibilité de la topologie avec un substrat générique. On s'assure de la sorte que le dispositif acoustique conçu à l'issue du procédé puisse être fabriqué à partir d'un tel substrat générique.

Ainsi, on veillera au cours de cette étape à ce que la forme et les dimensions (diamètre, longueur, largeur, et/ou profondeur) des membranes des transducteurs correspondent bien à la forme et aux dimensions des cavités d'un substrat générique.

On veillera également à ce que la disposition des transducteurs dans le plan de la topologie soit telle que, projetée sur la surface d'un substrat générique, chaque transducteur puisse être positionné au droit d'une cavité. Il n'est pas nécessaire toutefois que toutes les cavités d'un substrat générique correspondent à un transducteur, certaines cavités du substrat générique pouvant ne pas être employées dans le dispositif acoustique.

Ainsi, lorsqu'un substrat générique comprend des cavités regroupées selon des dimensions variées, comme c'est le cas du deuxième exemple de substrat générique illustré sur la figure 2c, on pourra définir la topologie du dispositif acoustique pour que seules les cavités d'une dimension particulière soient exploitées. Alternativement, on pourra exploiter la pluralité de groupes de cavités pour former des transducteurs ayant des propriétés différentes, comme cela a été décrit dans l'exemple susmentionné.

A titre d'exemple, cette dernière règle peut conduire à imposer que :
- les transducteurs soient répartis uniformément dans le plan pour chaque bloc de transducteurs, et disposés au nœud d'un quadrillage dont les génératrices sont perpendiculaires entre elles ;
- la distance séparant deux blocs adjacents corresponde à un multiple de la distance séparant deux transducteurs.

De la sorte, on s'assure que cette répartition ne soit pas incompatible avec un substrat générique du type décrit en référence à la figure 2, c'est à dire pour lequel les cavités sont uniformément réparties dans le plan du substrat.

Le procédé de conception n'est bien entendu pas limité à cette étape de définition de la topologie. Elle comprend d'autres étapes telles que la définition de l'épaisseur des membranes, la géométrie et le routage des électrodes au niveau de chaque bloc, la définition des zones de contact électrique autour de ces blocs, et toutes les autres étapes de conception qu'il est usuel de mettre en œuvre pour rendre fonctionnel les éléments micro-usinés et élaborer un modèle complet d'un dispositif acoustique.

La topologie déterminée peut s'écarter d'une topologie souhaitée, qui découlerait directement de l'analyse fonctionnelle du dispositif en cours de conception. Par exemple, la dimension et la forme imposées aux cavités composant les transducteurs pour qu'elles correspondent à la forme et la dimension des cavités du substrat générique peuvent conduire à définir une fréquence de résonance de la membrane différente de la fréquence qui était souhaitée dans les premières étapes du processus de conception.

Pour limiter l'impact de cet écart, un procédé conforme à l'invention peut comprendre une étape d'ajustement de certains paramètres du dispositif acoustique en cours de conception. Bien entendu cette étape d'ajustement ne peut concerner que des paramètres qui ne remettent pas en cause la compatibilité de la topologie avec le substrat générique. Un procédé conforme à l'invention peut également prévoir d'introduire des étapes complémentaires dans le procédé de fabrication du dispositif acoustique pour ajuster certains paramètres du dispositif au cours de sa fabrication.

A titre d'exemple, on peut envisager de modifier l'épaisseur de la membrane au cours de la fabrication du dispositif et ajuster ainsi la fréquence de résonnance d'un transducteur. On peut compenser de la sorte un éventuel écart de fréquence lié à la forme et/ou à la dimension des cavités imposées par le substrat générique. Cet ajustement, par épaississement ou amincissement, peut être réalisé au niveau de la membrane d'un transducteur particulier, d'un groupe de transducteurs, ou pour tous les transducteurs du dispositif acoustique. Le matériau de la couche d'épaississement peut être choisi pour affecter le comportement dynamique de la membrane.

Pour limiter l'impact des écarts, on pourra également faire en sorte de disposer d'un nombre suffisant de substrats génériques différents, bien répartis dans l'espace des choix de conception. Dans ce cas, pour toute topologie souhaitée il peut exister un substrat générique imposant une topologie déterminée qui soit suffisamment proche de la topologie souhaitée pour que l'impact sur les performances et les fonctionnalités du dispositif acoustique soit minimales.

Le procédé de conception d'un dispositif acoustique est naturellement mis en œuvre par des moyens informatiques. Ces moyens peuvent être configurés pour faciliter la définition la topologie déterminée, par exemple en déterminant automatiquement la topologie déterminée à partir d'une topologie souhaitée. Pour cela, le procédé doit avoir accès, par l'intermédiaire des moyens informatiques disponibles, aux caractéristiques prédéterminées du ou des substrats génériques.

Dans le cas où une collection ou un groupe de substrats génériques est disponible, le procédé peut rechercher et choisir le substrat générique le plus adapté du groupe et proposer la topologie déterminée la plus semblable de la topologie souhaitée, c'est à dire celle qui affecte le moins les fonctionnalités et/ou les performances du dispositif.

### Procédé de fabrication du dispositif acoustique.

Selon un autre aspect, l'invention porte également sur un procédé de fabrication d'un dispositif acoustique, et sur un dispositif issu de ce procédé. Comme on l'a noté précédemment, au moins certaines étapes de ce procédé de fabrication peuvent avoir été définies, au moins dans leurs paramètres principaux, au cours du procédé de conception lui-même.

Le procédé de fabrication comprend la fourniture d'un exemplaire du substrat générique retenu, au cours du procédé de conception, dans le groupe de substrats génériques. Usuellement, une pluralité de dispositifs peut être fabriquée, collectivement, sur un substrat générique au cours du procédé. On rappelle que le substrat générique présente des cavités dont les caractéristiques sont préétablies, les cavités étant respectivement associées à des membranes flexibles qui les surplombent.

Selon cet aspect de la présente description, le procédé de fabrication comprend au moins une étape de traitement, d'activation ou de désactivation, de certains seulement des couples formés d'une membrane et d'une cavité pour former au moins un élément micro-usiné fonctionnel et au moins un couple restant non fonctionnel, c'est à dire qui n'est pas apte à convertir un mouvement de sa membrane en un signal électrique ou inversement.

Certaines de ces étapes de traitement ne sont réalisées que sur les membranes du substrat générique désignées, dans la topologie, comme devant constituer un transducteur. Comme on l'a vu précédemment, il n'est donc pas nécessaire que les étapes de traitement conduisent à former des transducteurs pour toutes les cavités présentes dans le substrat générique. Ainsi, et en faisant à nouveau référence à la figure 1c, les zones séparant deux blocs adjacents de transducteurs ne seront pas traitées au cours de certaines de ces étapes de traitement, bien qu'elles surplombent des cavités du substrat générique.

En d'autres termes, au cours du procédé de fabrication, on active certains des couples formés d'une cavité et d'une membrane du substrat générique, pour former des éléments micro-usinés fonctionnels, c'est à dire en mesure de réciproquement convertir un mouvement de la membrane en un signal électrique. Le ou les couples cavités-membranes restants, non activés ou désactivés, ne seront donc pas exploités par le dispositif acoustique.

Ainsi, selon un mode de réalisation, les couples cavités-membranes du substrat générique restants, non retenus lors de la phase de conception, sont éliminés. Cette élimination peut être effectuée par une étape de traitement de gravure totale ou partielle des ensembles cavités-membranes associées.

Selon un autre mode de réalisation, les couples cavités-membranes du substrat générique restants, non retenus lors de la phase de conception, sont neutralisés, sans nécessairement en faire disparaitre toute trace. Une telle neutralisation peut être réalisée par une étape de traitement et prendre de multiples formes : blocage de la membrane flexible, interruption du routage d'interconnexion, décalage des points de fonctionnement par rapport à une fréquence de résonnance, ou encore par perçage de la membrane ...

Une étape de traitement peut également comprendre une étape d'ajustement de l'épaisseur de la couche superficielle, pour ajuster l'épaisseur des membranes surplombant les cavités. L'épaisseur ajustée des membranes peut être obtenue en épaississant ou en amincissant la couche superficielle. Cet amincissement ou épaississement peut être réalisé localement, au niveau de la membrane d'un transducteur particulier, d'un groupe de transducteurs, ou pour toutes les membranes du dispositif, en employant des techniques usuelles de photolithographie permettant de définir les zones à amincir et/ou épaissir. Un amincissement est préférentiellement réalisé par une étape de gravure : gravure chimique en solution, gazeuse ou plasma, oxydation sacrificielle, gravure physique par pulvérisation sous faisceau d'ions. Un épaississement est préférentiellement réalisé par dépôt du même matériau que celui formant initialement la membrane, en général du silicium. La couche déposée peut être monocristalline lorsqu'il s'agit d'une épitaxie. Mais elle peut aussi être polycrystalline, ou amorphe. Il est également possible de faire appel à d'autres matériaux pour réaliser au final des structures suspendues hétérogènes : par exemple un dépôt de SiO₂, de Si₃N₄ ou de métal sur une membrane d'origine en silicium monocristallin. Un épaississement peut aussi être réalisé par oxydation, en transformant une partie de l'épaisseur du film originel de silicium en SiO₂, oxydation qui s'accompagne d'un phénomène bien connu et maîtrisé de l'homme de l'art de gonflement de la couche. D'autres variations et ajustement d'épaisseur sont susceptibles d'intervenir à plusieurs étapes au cours du procédé de réalisation de fabrication du dispositif acoustique : par exemple lors de la formation d'une couche piézoélectrique, ou encore lors de la réalisation des électrodes.

Une étape de traitement peut également comprendre une étape de réalisation d'un réseau d'éléments électriquement conducteurs configuré pour connecter électriquement certains des couples cavité-membrane et rendre les éléments micro-usinés correspondant fonctionnels. La réalisation du réseau d'éléments électriquement conducteurs peut comprendre la formation d'électrodes, notamment au droit d'une partie seulement des cavités.

Selon que les transducteurs mis en œuvre sont de type capacitif ou piézoélectrique, le procédé de fabrication comprendra d'autres étapes de traitement nécessaires pour compléter la fabrication des transducteurs.

Il peut ainsi comprendre une étape de dépôt d'au moins une première électrode sur la couche superficielle, et dans le cas d'un transducteur piézoélectrique, une étape de dépôt d'une couche piézoélectrique sur la première électrode, et une étape de dépôt d'une seconde électrode sur la couche piézoélectrique.

Dans le cas d'un transducteur capacitif, il peut être nécessaire d'aménager une ouverture pour venir placer la seconde électrode au niveau du support.

A l'issue du procédé de fabrication, on dispose donc d'un dispositif acoustique comprenant un support, et une couche superficielle disposée sur la face principale du support. Le support présente des cavités débouchantes et les parties de la couche superficielle surplombant les cavités forment des membranes flexibles associées aux cavités. Une partie seulement des couples formés d'une cavité et d'une membrane flexible du substrat générique est configurée pour former un ensemble d'éléments micro-usinés fonctionnels, c'est à dire apte à réciproquement convertir un mouvement de la membrane en un signal électrique.

Comme on l'a déjà vu, les cavités et/ou les membranes du substrat générique qui ne sont pas activées, par exemple celles disposés dans les zones séparant deux blocs de transducteurs, peuvent être conservées, neutralisées ou éliminées, par exemple par gravure, sèche ou humide de la couche superficielle, de la couche intermédiaire si elle est présente, voire même d'une partie du support. On élimine ainsi les membranes flexibles non activées et les cavités qu'elles surplombent.

On peut également utiliser certaines zones non exploitées du substrat, comprenant néanmoins des cavités, comme chemin de découpe du substrat pour singulariser les dispositifs fabriqués collectivement sur le substrat générique les uns des autres.

Bien entendu l'invention n'est pas limitée aux modes de mise en œuvre et aux exemples décrits et on peut y apporter des variantes de réalisation sans sortir du cadre de l'invention tel que défini par les revendications.

L'invention n'est en particulier pas limitée à la conception ou à la fabrication de dispositifs acoustiques comprenant des transducteurs ultrasonores micro-usinés.

Il peut s'agir par exemple de transducteurs pouvant opérer dans d'autres gammes de fréquence que les ultrasons. On peut ainsi envisager de former des hauts parleurs ou des microphones matriciels. Chaque transducteur peut alors être adressé individuellement ou par paquets, ce qui est particulièrement intéressant pour le domaine de l'acoustique haute fidélité ou l'acoustique directionnelle.

Elle s'applique plus généralement à tout dispositif comprenant une pluralité d'éléments micro-usinés mettant en œuvre des membranes ou autres structures suspendues disposées en réseau dans un plan selon une topologie particulière et pouvant être traitées pour former des éléments micro-usinés fonctionnels.

Il peut ainsi s'agir par exemple d'éléments micro-usinés définissant des zones réfléchissantes pour former des réseaux de micro miroirs mobiles commandables. De tels microsystèmes peuvent être réalisés pour mettre en forme des faisceaux lumineux et sont à la base de nouveaux systèmes de projection, d'écrans ou de reconnaissance à distance. Dans ce cas, les membranes flexibles des substrats génériques forment le support des micro-miroirs devenus mobiles et commandables après qu'ils aient été fonctionnalisés selon la topologie déterminée lors de la phase de conception. Les cavités correspondent dans ce cas à l'évidement aménagé dans le substrat pour rendre possible le basculement des micro-miroirs. Les micro-miroirs peuvent être ancrés de plusieurs manières : sur la totalité ou une partie de leur contour, sur un pied unique central ou au contraire sur des pieds multiples et distribués. L'activation ou au contraire la désactivation d'une partie seulement des micro-miroirs peut s'effectuer de nombreuses manières : enlèvement simple par gravure sélective, libération ou au contraire blocage des micro-miroirs par suppression ou formation respectivement de points de blocage, formation ou au contraire enlèvement d'une couche réfléchissante sur les micro-miroirs, formation ou au contraire enlèvement d'une couche absorbante sur les micro-miroirs.

## Revendications

1. Procédé de fabrication d'un dispositif comprenant une pluralité d'éléments micro-usinés, le procédé comprenant :
- une étape de fourniture d'un substrat générique (20) comprenant une couche superficielle (23) disposée sur un support, la face principale du support (21) présentant des cavités débouchantes (24) et les parties de la couche superficielle surplombant les cavités formant des membranes flexibles associées auxdites cavités (24);
- au moins une étape de traitement de certains seulement des couples formés d'une membrane et d'une cavité pour former au moins un élément micro-usiné fonctionnel et au moins un couple restant qui n'est pas apte à convertir un mouvement de sa membrane en un signal électrique ou inversement, l'étape de traitement comprenant l'élimination ou la neutralisation d'une membrane et/ou une cavité non-retenue.

2. Procédé de fabrication selon l'une des revendications précédentes dans lequel au moins une étape de traitement comprend une étape de réalisation d'un réseau d'éléments électriquement conducteurs configuré pour connecter une partie seulement des couples cavité-membrane.

3. Procédé de fabrication selon la revendication précédente dans lequel la réalisation du réseau d'éléments électriquement conducteurs comprend la formation d'électrodes au droit d'une partie seulement des cavités.

4. Procédé de fabrication selon l'une des revendications précédentes comprenant une étape d'ajustement de l'épaisseur des membranes flexibles.

5. Procédé de fabrication selon l'une des revendications précédentes dans lequel le substrat générique (20) comprend également une couche intermédiaire (22) entre la face principale du support (21) et la couche superficielle (23).

6. Procédé de fabrication selon l'une des revendications précédentes comprenant une étape de dépôt d'au moins une première électrode sur la couche superficielle (23).

7. Procédé de fabrication selon la revendication précédente comprenant une étape de dépôt d'une couche piézoélectrique sur la première électrode.

8. Procédé de fabrication selon la revendication précédente comprenant une étape de dépôt d'une seconde électrode sur la couche piézoélectrique.

## Patentansprüche

1. Herstellungsverfahren einer Vorrichtung, die mehrere mikrobearbeitete Elemente umfasst, wobei das Verfahren Folgendes umfasst:
- einen Lieferungsschritt für ein generisches Substrats (20), das eine Oberflächenschicht (23) umfasst, die auf einem Träger angeordnet ist, wobei die Hauptfläche des Trägers (21) mündende Hohlräume (24) aufweist und die Teile der Oberflächenschicht in die Hohlräume hineinragen, die flexible Membranen ausbilden, die den Hohlräumen (24) zugeordnet sind;
- wenigstens einen Behandlungsschritt für nur gewisse Paare, die aus einer Membran und einem Hohlraum ausgebildet sind, zum Ausbilden wenigstens eines funktionellen mikrobearbeiteten Elements und wenigstens eines verbleibenden Paars, das nicht geeignet ist, eine Bewegung seiner Membran in ein elektrisches Signal umzuwandeln oder umgekehrt, wobei der Behandlungsschritt das Entfernen oder das Neutralisieren einer Membran und/oder eines nicht ausgewählten Hohlraums umfasst.

2. Herstellungsverfahren nach einem der vorhergehenden Ansprüche, wobei wenigstens ein Behandlungsschritt einen Ausführungsschritt für ein Netzwerk von elektrisch leitfähigen Elementen umfasst, das konfiguriert ist, um nur einen Teil der Hohlraum-Membran-Paare zu verbinden.

3. Herstellungsverfahren nach dem vorhergehenden Anspruch, wobei die Ausführung des Netzwerks von elektrisch leitfähigen Elementen die Ausbildung von Elektroden direkt unter nur einem Teil der Hohlräume umfasst.

4. Herstellungsverfahren nach einem der vorhergehenden Ansprüche, das einen Einstellungsschritt für die Dicke der flexiblen Membranen umfasst.

5. Herstellungsverfahren nach einem der vorhergehenden Ansprüche, wobei das generische Substrat (20) auch eine Zwischenschicht (22) zwischen der Hauptfläche des Trägers (21) und der Oberflächenschicht (23) umfasst.

6. Herstellungsverfahren nach einem der vorhergehenden Ansprüche, das einen Abscheidungsschritt für wenigstens eine erste Elektrode auf die Oberflächenschicht (23) umfasst.

7. Herstellungsverfahren nach dem vorhergehenden Anspruch, das einen Abscheidungsschritt für eine piezoelektrische Schicht auf die erste Elektrode umfasst.

8. Herstellungsverfahren nach dem vorhergehenden Anspruch, das einen Abscheidungsschritt für eine zweite Elektrode auf die piezoelektrische Schicht umfasst.

## Claims

1. Method for manufacturing a device comprising a plurality of micro-machined elements, the method comprising:
- a step of providing a generic substrate (20) comprising a surface layer (23) arranged on a carrier, the main face of the carrier (21) having emerging cavities (24) and the parts of the surface layer overhanging the cavities forming flexible membranes associated with said cavities (24); and
- at least one step of processing only some of the pairs formed by a membrane and a cavity in order to form at least one functional micro-machined element and at least one remaining pair which is not suitable for converting a movement of its membrane into an electrical signal, or vice versa, the processing step comprising the removal or neutralization of a membrane and/or a cavity which was not selected.

2. Manufacturing method according to the preceding claim, wherein at least one processing step comprises a step of producing a network of electrically conductive elements configured to connect only part of the cavity-membrane pairs.

3. Manufacturing method according to the preceding claim, wherein the production of the network of electrically conductive elements comprises the formation of electrodes in line with only part of the cavities.

4. Manufacturing method according to any of the preceding claims comprising a step of adjusting the thickness of the flexible membranes.

5. Manufacturing method according to any of the preceding claims, wherein the generic substrate (20) also comprises an intermediate layer (22) between the main face of the carrier (21) and the surface layer (23).

6. Manufacturing method according to any of the preceding claims comprising a step of depositing at least a first electrode on the surface layer (23).

7. Manufacturing method according to the preceding claim comprising a step of depositing a piezoelectric layer on the first electrode.

8. Manufacturing method according to the preceding claim comprising a step of depositing a second electrode on the piezoelectric layer.
